# EUROPEAN PATENT APPLICATION

(11) **EP 4 401 114 A1**
(43) Date of publication of application: **17.07.2024**
(21) Application number: 22866952.9
(22) Date of filing: 17.03.2022
(51) Int. Cl.: H01L 21/304

(54) **DEVICE FOR SUPPLYING LIQUID FOR SEMICONDUCTOR MANUFACTURING**

(30) Priority: 07.09.2021 JP 2021145469
(71) Applicant: Kurita Water Industries Ltd., Tokyo 164-0001 (JP)
(72) Inventor: IINO, Hideaki, Tokyo 164-0001 (JP)
(74) Representative: TBK
(86) International application number: PCT/JP2022/012177
(87) International publication number: WO 2023/037618

(57) **Abstract**

A device for supplying liquid for semiconductor manufacturing 1 according to the present invention has a supply pipe 2 communicating with a supply source of ultrapure water W, a conductivity modifier supply mechanism 3 and an oxidation reduction potential modifier supply mechanism 4 provided midway in this supply pipe 2, a membrane-type deaerator 5, and a particulate removal filter 6. The supply pipe 2 branches into a main pipe 7 and a drain pipe 8. The main pipe 7 is provided with a first instantaneous flow meter 10, and is further in communication with a single wafer-cleaning device 9. The drain pipe 8 is provided with a second instantaneous flow meter 11, and is further provided with a flow-regulating valve 12. A sensor unit 13 is provided between the membrane-type deaerator 5 and the particulate removal filter 6. A control means 15 can control the flow-regulating valve 12. According to the present invention, even if the flow rate used by the wafer cleaning device fluctuates, it is possible to stably supply with good accuracy a solute concentration of the liquid for semiconductor manufacturing at a desired value.

## Description

### Technical Field

The present invention relates to relates to a device for supplying liquid for semiconductor manufacturing that can efficiently and stably supply a solution containing an acid, alkali, or an organic solvent for suppressing corrosion and dissolution to wiring materials exposed in minute trenches and pores formed by dry etching etc., or deliquescent compounds used in gates during a cleaning and rinsing process of semiconductor wafers.

### Description of Related Art

In recent years, with the miniaturization, three-dimensionalization, and high integration of semiconductor device structures, low-resistance materials such as copper, tungsten, cobalt, and molybdenum have been adopted from the perspective of reducing wiring resistance. Since the metals are easily corroded, liquid (hereinafter referred to as liquid for semiconductor manufacturing) in which a solute that is effective for controlling pH and oxidation reduction potential is dissolved at very low concentration or less than several tens of percent is required in the cleaning and rinsing process of silicon wafers and the like to prevent corrosion. Furthermore, materials such as MgO and La₂O₃, which exhibit deliquescent properties in water, may be used as gate materials. In such cases, strict concentration control of pH and oxidation reduction potential or combined use with an organic solvent is unavoidable. The liquid for semiconductor manufacturing is mainly used as cleaning and rinsing liquid in a single wafer cleaning device.

The liquid for semiconductor manufacturing uses ultrapure water as a basic material thereof, and in order to have liquid properties such as pH and oxidation reduction potential that match the purpose of the cleaning and rinsing process, the liquid for semiconductor manufacturing is prepared by adding the required amount of acid/alkali, oxidizing agent/reducing agent. Alternatively, ultrapure water is used as a diluent for a chemical solution. Furthermore, reducing, alkaline, and acidic gases such as H₂, NH₃, and O₃ may be dissolved in ultrapure water, and are used depending on the purpose. As methods for supplying liquid for semiconductor manufacturing, there are a method using a pump and a method using a closed container and pressurization with an inert gas such as N₂, and each of which has been put to practical use.

In particular, in terms of the performance of a device that supplies liquid for semiconductor manufacturing regulated to low concentration to a point of use formed by multiple single wafer cleaning devices, the capability to follow flow rate fluctuations due to changes in the number of machines in operation of devices is most important from the perspective of improving yield. There are two main types of flow rate fluctuations when sending liquid for semiconductor manufacturing to the single wafer cleaning device. One is the flow rate fluctuation that occurs when starting up the cleaning device itself and starting to use a desired cleaning solution as liquid for semiconductor manufacturing from a state where the desired cleaning solution has not been used at all. The above flow rate fluctuation can be avoided by preprogramming the period required for the cleaning solution to rise to the desired water quality in the timing chart of the wafer cleaning machine. That is, during the initial stage of startup until the concentration stabilizes at a specified value, the liquid may be sent to the drain pipe and discharged, so that the liquid is not used for wafer cleaning.

On the other hand, since a cleaning solution regulated to low concentration is used at a constant flow rate in the single wafer cleaning device, which is the point of use, if the flow rate of the cleaning solution changes frequently due to changes in the number of machines in operation of single wafer cleaning devices, etc., a feedback control method using a flow meter and a water quality meter, or a proportional control method using a flow meter is used to cope with the situation. However, with a one-time type device for supplying liquid for semiconductor manufacturing that prepares and supplies a cleaning solution according to the amount used at the point of use, both of the control methods have limitations in controlling the concentration in the middle of the water flow path. The capability to follow concentration fluctuations in a flow rate is not very high, and there are limits to the capability of a flow meter and feedback control and proportional control of the flow meter alone to meet the strict concentration control required by the semiconductor industry.

There is also a supply device of a cleaning solution by a tank storage type in which the cleaning solution diluted to low concentration is temporarily stored in a tank and then sent by gas pressure or a pump. In the case of the tank storage type, a cleaning solution exceeding the tank capacity cannot be sent, which limits the use of such a device in the wafer cleaning device. Furthermore, if the tank capacity is made too large, it is inconvenient because storing liquid for semiconductor manufacturing takes time and securing installation space is required. Furthermore, in the tank storage type, the cleaning solution in the tank has to be disposed of once every time a concentration change is required by the wafer cleaning device, which is not a good idea from the standpoint of environmental burden.

Therefore, when supplying liquid for semiconductor manufacturing such as a cleaning solution, in order to keep the solute concentration within a desired range, the solute concentration is controlled by various methods such as PID control based on a signal from a concentration monitor, proportional control for an ultrapure water flow rate, etc. For example, Patent Literature 1 discloses a flow-regulating means using a magnetic mechanism for the purpose of precisely controlling the amount of functional fluid dissolved or mixed in ultrapure water to generate functional water with accurate functional fluid concentration. Furthermore, Patent Literature 2 proposes a flow rate control mechanism for a device for supplying gas-dissolved water for cleaning that controls the supply amount of other fluids based on a flow meter that measures the flow rate of the main fluid and outputs a signal of the measured value and the signal input as a flow rate control method. Furthermore, in Patent Literature 3, a supply device for liquid processing to a substrate is proposed in which the concentration is controlled by applying feedback control to a flow rate control valve based on a flow rate value described in a recipe for wafer cleaning water used in a single wafer cleaning device.

### Related Art

### Patent Literature

Patent Literature 1: Japanese Patent No. 4786955
Patent Literature 2: Japanese Patent Application Laid-Open No. 2003-334433
Patent Literature 3: Japanese Patent Application Laid-Open No. 2018-206876

### SUMMARY

### Technical Problem

However, although the flow-regulating means using a magnet mechanism described in Patent Literature 1 allows accurate mixing, there is a problem in that the capability to follow fluctuations in the flow rate is insufficient. Furthermore, in the flow rate control method of the device for supplying gas-dissolved water for cleaning described in Patent Literature 2, when applied to a single wafer cleaning device, there is a problem in that the capability to follow the flow rate is not sufficient when the amount used in a single wafer cleaning device changes during liquid sending. Moreover, the supply device for liquid processing to a substrate according to Patent Literature 3 has a problem in that it is difficult to control minute concentration when the flow rate fluctuates in a single wafer cleaning device.

The present invention has been made in view of the above problems, and an object is to provide a device for supplying liquid for semiconductor manufacturing that enables the solute concentration of liquid for semiconductor manufacturing to be regulated to a desired value with high precision, and can stably supply liquid for semiconductor manufacturing even if the flow rate used in the wafer cleaning device fluctuates.

### Solution to the Problem

In order to achieve the above-mentioned object, the present invention provides a device for supplying liquid for semiconductor manufacturing, which includes: a supply pipe supplying a solvent; a preparation unit which prepares liquid for semiconductor manufacturing with predetermined concentration by adding a predetermined amount of a chemical solution to the solvent; and a concentration control unit which manages the preparation unit so that the liquid for semiconductor manufacturing has predetermined concentration of the chemical solution. The supply pipe branches into a drain pipe connected to the supply pipe at a stage subsequent to the concentration control unit and a main pipe communicating from a connection unit of the drain pipe to a point of use. The main pipe is provided with a flow rate measuring means, and the drain pipe is provided with a flow-regulating mechanism that can correspond to a measured value of the flow rate measuring means (first embodiment). In particular, in the above embodiment (first embodiment), it is exemplary that the flow rate of the main pipe can be controlled by setting a total flow rate of the main pipe and the drain pipe to approximately the maximum usage amount at the point of use and varying a flow rate of the drain pipe by the flow-regulating mechanism (second embodiment).

According to such embodiments (first and second embodiments), by setting the total flow rate of the main pipe and the drain pipe as the maximum flow rate required by the wafer cleaning device, and regulating the flow rates of the two flow paths of the main pipe and the drain pipe by the opening degree of a flow-regulating valve of the drain pipe, the liquid for semiconductor manufacturing can always be supplied to the point of use without concentration fluctuations by varying the flow rate of the drain pipe in response to the variation in the usage amount at the point of use.

In the above embodiments (first and second embodiments), it is exemplary that the flow-regulating mechanism is a valve, and the flow rate is regulated by regulating the opening degree of the valve (third embodiment). Further, in the above embodiments (first and second embodiments), it is exemplary that the flow-regulating mechanism is a flow-regulating valve or a constant pressure valve (fourth embodiment).

According to such embodiments (third and fourth embodiments), by regulating the flow rate of the drain pipe by a valve, a flow-regulating valve, a constant pressure valve, etc., an amount of the liquid for semiconductor manufacturing corresponding to the usage amount at the point of use can be supplied to the main pipe.

In the above embodiments (first to fourth embodiments), as a means for injecting the chemical solution, it is exemplary to use a pump or a transportation means that pressurizes a closed tank filled with a chemical solution with an inert gas and pushes out the chemical solution (fifth embodiment).

According to the embodiment (fifth embodiment), by controlling the amount of the chemical solution added to the flow rate of the solvent such as ultrapure water using the injection means, the liquid for semiconductor manufacturing of desired concentration can be supplied. can do.

In the above embodiments (first to fifth embodiments), the chemical solution is a conductive solute, and the concentration control unit includes a conductivity meter or an absorption photometer. It is exemplary that the amount of the chemical solution added can be controlled based on a measured value of the conductivity meter or the absorption photometer (sixth embodiment).

According to the embodiment (sixth embodiment), by calculating the concentration of a chemical solution that is a conductive solute in liquid for semiconductor manufacturing based on the measured value of the conductivity meter or the absorption photometer, and controlling the injection amount of the chemical solution based on the calculated value, the liquid for semiconductor manufacturing having a predetermined concentration range can be supplied with respect to set concentration of the chemical solution.

In the above embodiments (first to fifth embodiments), the chemical solution is a non-conductive solute, and the concentration control unit includes a TOC meter or an absorption photometer. It is exemplary that the amount of the chemical solution added can be controlled based on a measured value of the TOC meter or the absorption photometer (seventh embodiment).

According to the embodiment (seventh embodiment), by calculating the concentration of the chemical solution, which is a non-conductive solute in the liquid for semiconductor manufacturing, based on the measured value of the TOC meter or the absorption photometer, and controlling the injection amount of the chemical solution based on the calculated value, the liquid for semiconductor manufacturing having a predetermined concentration range can be supplied with respect to the set concentration of the chemical solution.

### Effects

According to the device for supplying liquid for semiconductor manufacturing of the present invention, the total flow rate of the main pipe and the drain pipe is set as the maximum flow rate required by the wafer cleaning device, the flow rates of the two flow paths of the main pipe and the drain pipe are regulated by the opening degree of the flow-regulating valve of the drain pipe, and by varying the flow rate of the drain pipe in response to variations in the usage amount at the point of use, the liquid for semiconductor manufacturing can always be supplied without concentration fluctuations. In this way, for example, the solute concentration of the liquid for semiconductor manufacturing can be precisely regulated to a desired value for the wafer surface in which a corrosive or deliquescent material is embedded. Moreover, the device for supplying liquid for semiconductor manufacturing that can stably supply liquid for semiconductor manufacturing can be provided even if the flow rate used in the wafer cleaning device fluctuates.

### BRIEF DESCRIPTION OF THE DRAWINGS

FIG. 1 is a flow diagram showing a device for supplying liquid for semiconductor manufacturing according to an embodiment of the present invention.
FIG. 2 is a flowchart showing an example of a means for injecting a chemical solution of the device for supplying liquid for semiconductor manufacturing of the same embodiment.
FIG. 3 is a flow diagram showing another example of a means for injecting a chemical solution of the device for supplying liquid for semiconductor manufacturing of the same embodiment.
FIG. 4 is a flow diagram showing a one-time type device for supplying liquid for semiconductor manufacturing of Comparative Example 1.
FIG. 5 is a graph showing the variation in the required amount of water at the point of use and the conductivity of the liquid for semiconductor manufacturing in Example 1.
FIG. 6 is a graph showing the variation in the required amount of water at the point of use and the conductivity of the liquid for semiconductor manufacturing in Comparative Example 1.

### DESCRIPTION OF EMBODIMENTS

The device for supplying liquid for semiconductor manufacturing according to the present invention will be described in detail below with reference to the accompanying drawings.

### [Device for supplying liquid for semiconductor manufacturing]

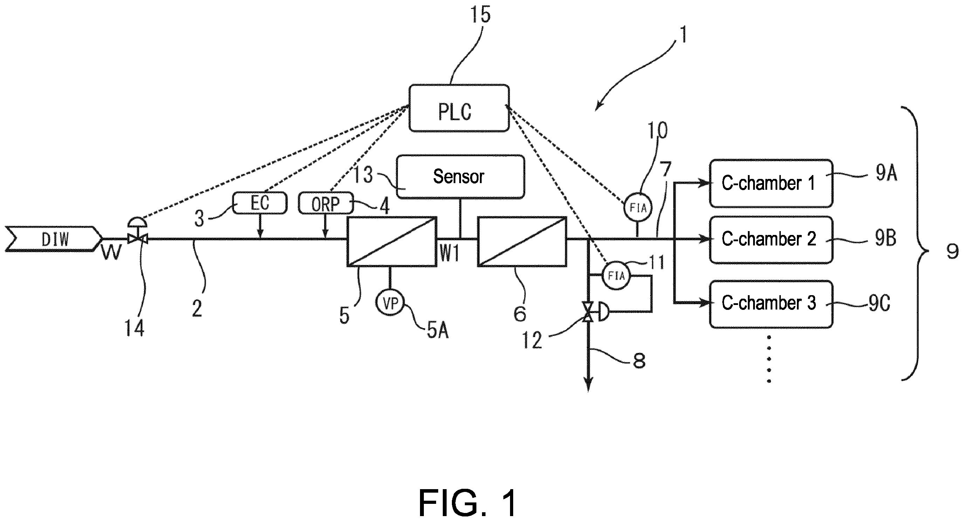

FIG. 1 shows a device for supplying liquid for semiconductor manufacturing according to an embodiment of the present invention. In FIG. 1, a device for supplying liquid for semiconductor manufacturing 1 includes a supply pipe 2 communicating with a supply source of ultrapure water W as a solvent, a conductivity modifier supply mechanism 3 and an oxidation reduction potential modifier supply mechanism 4 as a preparation unit provided midway in the supply pipe 2, a membrane-type deaerator 5 as a degassing means equipped with a vacuum pump 5A, and a particulate removal filter 6 such as an ultrafiltration membrane. The supply pipe 2 branches into a main pipe 7 and a drain pipe 8 by connecting the drain pipe 8 at a stage subsequent to the particulate removal filter 6. The main pipe 7 is provided with a first instantaneous flow meter 10, and further communicates with a single wafer cleaning device 9 as a point of use. The single wafer cleaning device 9 has multiple cleaning machine chambers 9A, 9B, 9C, etc. Further, the drain pipe 8 is provided with a second instantaneous flow meter 11, and a flow-regulating valve 12 as a flow-regulating mechanism is provided attached to the second instantaneous flow meter 11. As the flow-regulating valve 12, it is exemplary to use one that is easy to control and has a short response, such as an air-driven type or an electromagnetic type.

Further, a sensor unit 13 as a concentration control unit is provided between the membrane-type deaerator 5 and the particulate removal filter 6. The sensor unit 13 may be appropriately selected and used to suitably detect the concentration of a conductivity modifier and an oxidation reduction potential modifier, and may be formed by one or more of a conductivity meter, an ORP meter, etc. Alternatively, for a chemical solution such as ozone that are difficult to detect with a conductivity meter, a sensor such as a concentration measuring device using a flow meter and a UV absorbance method may be used. Furthermore, a TOC meter or the like may be provided as required. Note that 14 is a flow-regulating valve as a flow-regulating mechanism for controlling the flow rate of the supply pipe 2.

The first instantaneous flow meter 10, the second instantaneous flow meter 11, and the sensor unit 13 can transmit measured values to a control means 15 such as a programmable logic controller (PLC). Based on the transmission results, the control means 15 can control the conductivity modifier supply mechanism 3, the oxidation reduction potential modifier supply mechanism 4, the flow-regulating valve 12, and the flow-regulating valve 14.

### (Preparation unit)

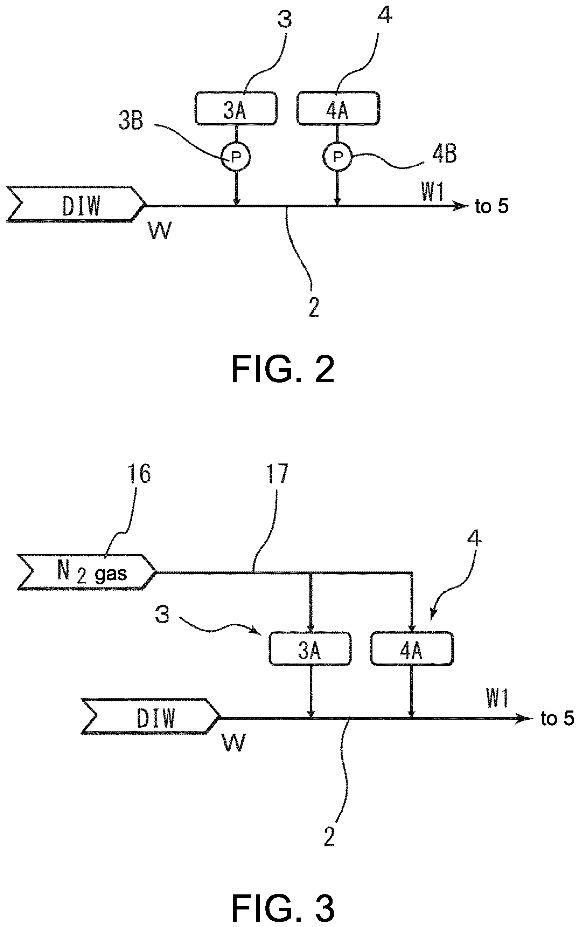

The preparation unit includes the conductivity modifier supply mechanism 3 and the oxidation reduction potential modifier supply mechanism 4 provided midway in the supply pipe 2. In the embodiment, as shown in FIG. 2, the conductivity modifier supply mechanism 3 and the oxidation reduction potential modifier supply mechanism 4 are each formed by a tank 3A for a conductivity modifier and a plunger pump 3B for adding a chemical solution and a tank 4A for an oxidation reduction potential modifier and a plunger pump 4B for adding a chemical solution. The amount of each of chemical solutions injected can be regulated by controlling the plunger pumps 3B and 4B by the control means 15. Note that the conductivity modifier supply mechanism 3 may also function as a pH modifier supply mechanism. Furthermore, either the conductivity modifier supply mechanism 3 or the oxidation reduction potential modifier supply mechanism 4 may be used alone.

It is desirable to homogenize the chemical solution by installing a line mixing device such as a static mixer in the concentration regulation unit after adding the chemical solution. However, by regulating the piping system and the flow rate during transfer and mixing so that the Reynolds number is 4000 or more, if the viscosity and density of each of liquid are approximately ±20%, in particular, there is no need to install a static mixer, and if the pipe has an elbow or orifice, the chemical solution can be sufficiently mixed and homogenized.

### (Ultrapure water)

In the embodiment, it is exemplary that the ultrapure water W serving as the raw water is, for example, a resistivity of 18.1 MΩ·cm or more, fine particles: 1000 particles/L or less with a particle size of 50 nm or more, viable bacteria: 1 particle/L or less, Total Organic Carbon (TOC): 1 µg/L or less, total silicon: 0.1 µg/L or less, metals: 1 ng/L or less, ions: 10 ng/L or less, hydrogen peroxide: 30 µg/L or less, and water temperature: 25±2° C.

### (Chemical solution)

In the embodiment, there are no particular limitations on the conductivity modifier, but when regulating the pH to less than 7, an acidic solution such as hydrochloric acid, nitric acid, sulfuric acid, or acetic acid can be used. Moreover, when regulating the pH to 7 or higher, an alkaline solution such as ammonia, sodium hydroxide, potassium hydroxide, or TMAH can be used. Further, a gas such as CO₂ may be used depending on the case.

Further, as the oxidation reduction potential modifier, when regulating the oxidation reduction potential to a high level, a hydrogen peroxide solution or the like can be used. Further, in order to regulate the oxidation reduction potential to a low value, a solution of oxalic acid, hydrogen sulfide, potassium iodide, etc. can be used. Further, a gas such as ozone (O₃) or hydrogen (H₂) may be used depending on the case.

### [Method for supplying dilute chemical solution]

Next, a method for supplying liquid for semiconductor manufacturing using the device for supplying liquid for semiconductor manufacturing as described above will be described below.

### (Preparation process for liquid for semiconductor manufacturing)

In addition to supplying the ultrapure water W from a supply source of ultrapure water (DIW) W, a conductivity modifier and an oxidation reduction potential modifier from the conductivity modifier supply mechanism 3 and the oxidation reduction potential modifier supply mechanism 4 are respectively supplied. At this time, the flow rate of the ultrapure water W is controlled by the control means 15 using the flow-regulating valve 14 so as to reach the maximum amount when all the cleaning machine chambers 9A, 9B, 9C, etc. of the single wafer cleaning device 9 as the point of use are in operation. Based on the flow rate of the ultrapure water W, the conductivity modifier supply mechanism 3 and the oxidation reduction potential modifier supply mechanism 4 are controlled by a control device 15 so that the conductivity modifier and the oxidation reduction potential modifier have predetermined concentration, and the amounts of conductivity modifier and the oxidation reduction potential modifier are regulated. Note that either one of the conductivity modifier and the oxidation reduction potential modifier may be added. The chemical solution prepared in such a manner is sent to the membrane-type deaerator 5, and dissolved gas components are removed, thereby preparing liquid for semiconductor manufacturing W1.

Here, it is effective for the liquid for semiconductor manufacturing W1 to be an alkaline solution for a semiconductor material using copper, cobalt, La₂O₃, MgO, etc, in particular, it is desirable to effectively suppress the dissolution of the materials within the pH range of 9 to 11. Also, when the semiconductor material contains copper and cobalt, passivation occurs by regulating the pH of the liquid for semiconductor manufacturing W1 to the pH range of 9 to 11 and the oxidation reduction potential to a range of 0.1 to 1.7V, and further dissolution can be expected to be suppressed. However, since the dissolution suppressing effect is observed even under alkaline conditions alone, the oxidation reduction potential is not limited thereto. As for the type of alkali, ammonia is desirable in terms of preventing contamination during rinsing, but even if other alkaline solutions such as TMAH or sodium hydroxide are used, there is no problem in suppressing dissolution and penetration. On the other hand, if the semiconductor material contains tungsten or molybdenum, it is effective for the liquid for semiconductor manufacturing W1 to be an acidic solution, and in particular, from the viewpoint of reducing the consumption amount of the chemical solution, it is desirable that the liquid for semiconductor manufacturing W1 has a pH of 2 to 5. Further dissolution can be expected to be suppressed by lowering the oxidizing agent and dissolved oxygen concentration. Dilution of hydrochloric acid or dissolution of carbon dioxide gas is widely known for preparing the acidic solution, and the aforementioned is desirable from the viewpoint of suppressing contamination.

### (Concentration control process)

The liquid for semiconductor manufacturing W1 prepared in this way has the conductivity, oxidation reduction potential (ORP), etc. thereof measured by the sensor unit 13 serving as a concentration control unit, and the measured value is transmitted to the control means 15. The control means 15 regulates the amount of conductivity modifier added by controlling the plunger pump 3B of the conductivity modifier supply mechanism 3 as needed based on the value of the conductivity. On the other hand, based on the value of the oxidation reduction potential, the amount of the oxidation reduction potential modifier added is regulated by controlling the plunger pump 4B of the oxidation reduction potential modifier supply mechanism 4 as necessary. In this way, the conductivity and the oxidation reduction potential of the liquid for semiconductor manufacturing W1 can always be regulated to desired values. Furthermore, when varying the conductivity and the oxidation reduction potential of the liquid for semiconductor manufacturing W1, the liquid for semiconductor manufacturing W1 can be rapidly prepared in the same manner.

In such a concentration control process, it is desirable that the control means 15 is equipped with an in-line monitor for control that displays the measured value of the sensor unit 13, etc., and the concentration of each of solutions is controlled to within an error of ±5. In addition, concentration fluctuations are likely to occur when the amount used in the single wafer cleaning device 9 varies. However, by controlling the injection amount of the chemical solution, gas supply amount, etc. by the output of the second instantaneous flow meter 11 and the flow-regulating valve 12 installed in the drain pipe 8 and the first instantaneous flow meter 10 installed in the main pipe 7, even if the flow rate used in the single wafer cleaning device 9 fluctuates, concentration fluctuations can be suppressed to a minimum range, and the stable cleaning liquid for semiconductor manufacturing W1 can be sent to the single wafer cleaning device 9.

### (Process of supplying the liquid for semiconductor manufacturing W1)

Next, the liquid for semiconductor manufacturing W1 passes through the particulate removal filter 6 and is then supplied from the main pipe 7 to the single wafer cleaning device 9. At this time, the flow rate of the main pipe 7 is the total amount used by the cleaning machine chambers 9A, 9B, 9C, etc. which are in operation, and therefore varies depending on the number of machines in operation of the respective cleaning machine chambers. In the embodiment, the main pipe 7 is provided with the first instantaneous flow meter 10 so that the flow rate of the main pipe 7 is measured, and the measured value is transmitted to the control means 15. Since the flow rate of the ultrapure water W supplied to the supply pipe 2 is set to be the maximum amount when all of the cleaning machine chambers 9A, 9B, 9C, etc. of the single wafer cleaning device 9 as the point of use are in operation, the control means 15 quickly regulates the opening degree of the flow-regulating valve 12 so that the difference between the maximum amount and the used amount becomes the flow rate of the drain pipe 8, and discharges the water from the drain pipe 8 as drain water D. As a result, the flow rate of the supply pipe 2, that is, the preparation amount of the liquid for semiconductor manufacturing W1 can always be kept constant, even if the number of machines in operation of the respective cleaning machine chambers varies and the amount of the liquid for semiconductor manufacturing W1 used varies, the liquid for semiconductor manufacturing W1 can be supplied with a minimal concentration fluctuation within a predetermined concentration range. Note that the drain water D may be discharged as is, or may be returned to the supply source of the ultrapure water W after removing the conductivity modifier and the oxidation reduction potential modifier through various treatments.

Although the device for supplying liquid for semiconductor manufacturing of the present invention has been described above based on the embodiments described above, the present invention is not limited to the embodiments described above and can be implemented in various modifications. For example, the conductivity modifier supply mechanism 3 and the oxidation reduction potential modifier supply mechanism 4 of the preparation unit are not limited to the conductivity modifier supply mechanism 3 and the oxidation reduction potential modifier supply mechanism 4 of the preparation unit shown in FIG. 2. As shown in FIG. 3, the tank 3A for the conductivity modifier and the tank 4A for the oxidation reduction potential modifier are sealed tanks, an N₂ gas supply source 16 as an inert gas supply source is connected to the tank 3A and the tank 4A, an N₂ gas as an inert gas is supplied from the N₂ gas supply source 16 via a supply pipe 17 by a flow-regulating mechanism (not shown), and the conductivity modifier and the oxidation reduction potential modifier may be added under pressure to obtain desired solute concentration. Further, the present invention is applicable not only to the ultrapure water W but also to an organic solvent such as IPA as a solvent.

Furthermore, the configuration of the sensor unit 13 may be changed as appropriate depending on whether the solute is conductive or non-conductive. For example, in the case of a conductive solute, a conductivity meter and an absorption photometer may be provided, and in the case of a non-conductive solute, a TOC meter and an absorption photometer may be provided.

Furthermore, in the embodiments described above, a gas dissolving membrane may be provided to dissolve desired gas components into the liquid for semiconductor manufacturing W1. Note that a buffer pipe or a storage tank may be provided midway in the supply pipe 2, or a heater for a solution or the like may be provided. Furthermore, the point of use is not limited to the single wafer cleaning device 9, but can be applied to devices that use various liquid for semiconductor manufacturing.

### [Example]

The present invention will be described in further detail by the following specific examples.

### [Example 1]

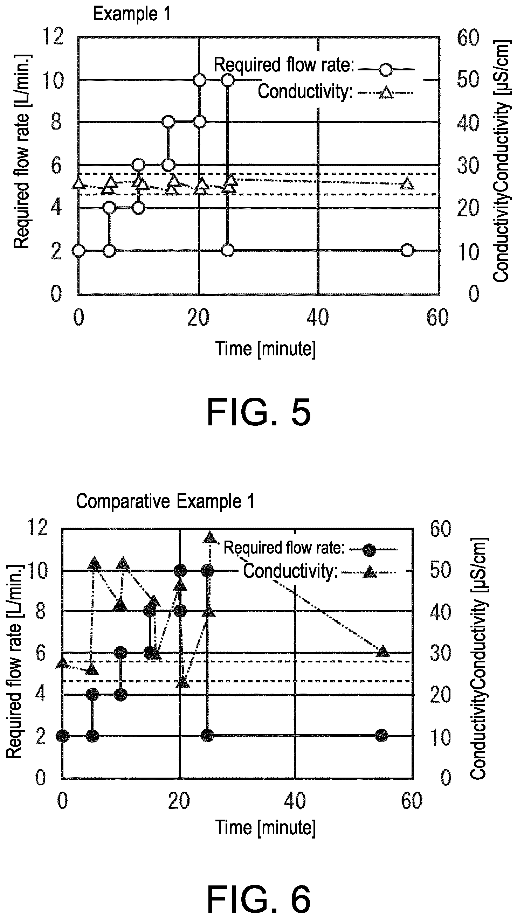

In the device for supplying liquid for semiconductor manufacturing 1 shown in FIG. 1, the main pipe 7 was connected to a single wafer cleaning device 9, and wafers laminated with cobalt were cleaned. At this time, ammonia water was supplied from the conductivity modifier supply mechanism 3, and the ammonia water diluted to 10 ppm was used as a cleaning solution (liquid for semiconductor manufacturing W1). Note that the oxidation reduction potential modifier supply mechanism 4 was set so as not to supply anything. The goal of the cleaning solution was to have a conductivity of 25 µS/cm±10%. The single wafer cleaning device 9 has five chambers for processing, and each of the chambers requires 2 L/min of the cleaning solution. The operation/stop of each of the chambers was controlled in a simulated manner, and the amount of the cleaning solution sent to the single wafer cleaning device 9 was changed. At this time, the flow rate of the supply pipe 2 was set to 10 L/min, which is the maximum flow rate required by the wafer cleaning device. In such processing, the conductivity of the cleaning solution was measured in response to fluctuations in the amount of the cleaning solution required to the single wafer cleaning device 9. The results are shown in FIG. 5.

### [Comparative Example 1]

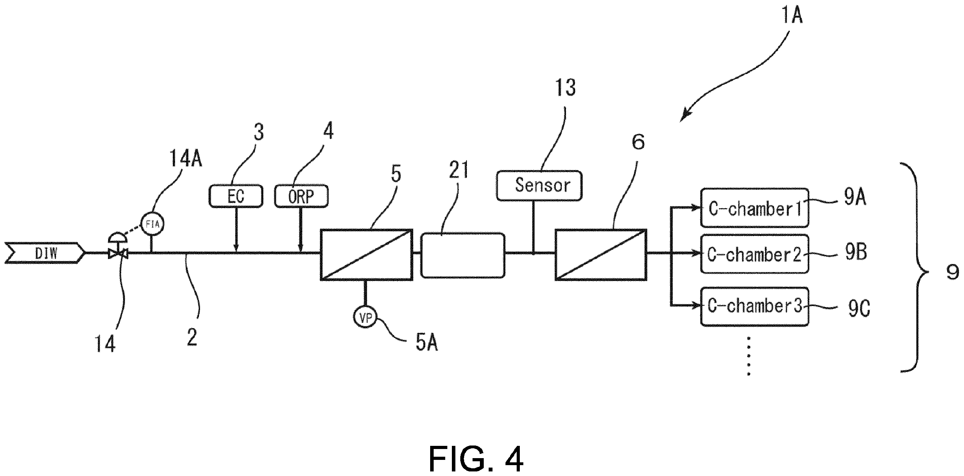

A one-time type device for supplying liquid for semiconductor manufacturing shown in FIG. 4 was prepared. In a device for supplying liquid for semiconductor manufacturing 1A shown in FIG. 4, the same components as the components in FIG. 1 are designated by the same reference numerals, and detailed description thereof will be omitted. The device for supplying liquid for semiconductor manufacturing 1A shown in FIG. 4 does not have the drain pipe 8, but instead has a buffer pipe 21 provided at a stage subsequent to the membrane-type deaerator 5. The supply pipe 2 is provided with the flow-regulating valve 14 equipped with an instantaneous flow meter 14A. Then, a control device (not shown) follows the required flow rate of the single wafer cleaning device 9 and regulates the opening degree of the flow-regulating valve 14 of the supply pipe 2 each time to regulate the flow rate, and the amount of ammonia water supplied from the conductivity modifier supply mechanism 3 was regulated so that the ammonia water diluted to 10 ppm was set to prepare the cleaning solution (liquid for semiconductor manufacturing W1) and supplied to the single wafer cleaning device 9.

The operation/stop of the five chambers for processing of the single wafer cleaning device was controlled in a simulated manner, and the amount of the cleaning solution sent to the single wafer cleaning device 9 was changed in the same manner as in Example 1. The conductivity of the cleaning solution was measured in response to fluctuations in the amount of the cleaning solution required for the single wafer cleaning device 9. The results are shown in FIG. 6. Furthermore, Table 1 shows the results of calculating the number of chambers that can be accommodated in the wafer cleaning device in Example 1 and Comparative Example 1 from the results.

**[Table 1]**

| Ex. No. | Flow regulation of drain pipe | Number of operating wafer cleaning machines in operation [unit] | Required flow rate of wafer cleaning machine [L/min] | Number of chambers that can pass water [piece] |
|---|---|---|---|---|
| Example 1 | Yes | 1 | 2 | 1 |
| | Yes | 2 | 4 | 2 |
| | Yes | 3 | 6 | 3 |
| | Yes | 4 | 8 | 4 |
| | Yes | 5 | 10 | 5 |
| Comparative Example 1 | No | 1 | 2 | 1 |
| | No | 2 | 4 | 0 |
| | No | 3 | 6 | 0 |
| | No | 4 | 8 | 0 |
| | No | 5 | 10 | 0 |

As is clear from FIGS. 5 and 6 and Table 1, in the device for supplying liquid for semiconductor manufacturing of Example 1, it was found that even if the flow rate fluctuated, the concentration remained within a ±10% range. It can be seen that by constantly passing dilute ammonia water through the supply pipe 2 at a rate of 10 L/min, which is the maximum required flow rate of the wafer cleaning device, even if the required flow rate of the wafer cleaning device fluctuates during the process, such fluctuations can be followed, and dilute ammonia water with a stable concentration can be supplied according to the required flow rate. On the other hand, in Comparative Example 1, which is a one-time type device for supplying liquid for semiconductor manufacturing, an attempt was made to regulate the concentration as the flow rate fluctuated, but the measure could not keep up, resulting in significant fluctuations in the concentration. From this, it can be seen that even if the supply pipe 2 is equipped with the buffer pipe 21 to alleviate fluctuations in concentration in the one-time type, the fluctuations in the flow rate cannot be followed, and short-term fluctuations make it difficult to supply a cleaning solution with predetermined conductivity.

### Reference Signs List

1: Device for supplying liquid for semiconductor manufacturing
2: Supply pipe
3: Conductivity modifier supply mechanism (preparation unit)
   3A: Tank
   3B: Plunger pump
4: Oxidation reduction potential modifier supply mechanism (preparation unit)
   4A: Tank
   4B: Plunger pump
5: Membrane-type deaerator
5A: Vacuum pump
6: Particulate removal filter
7: Main pipe
8: Drain pipe
9: Single wafer cleaning device
9A, 9B, 9C, etc.: Cleaning machine chamber
10: First instantaneous flow meter
11: Second instantaneous flow meter
12: Flow-regulating valve (flow-regulating mechanism)
13: Sensor unit (concentration control unit)
14: Flow-regulating valve
15: Control means
16: N₂ gas supply source (inert gas supply source)
17: Supply pipe
W: Ultrapure water
W1: Liquid for semiconductor manufacturing
D: Drain water

## Claims

1. A device for supplying liquid for semiconductor manufacturing, comprising:
a supply pipe, supplying a solvent;
a preparation unit, preparing liquid for semiconductor manufacturing with predetermined concentration by adding a predetermined amount of a chemical solution to the solvent;
a concentration control unit, managing the preparation unit so that the liquid for semiconductor manufacturing has predetermined concentration of the chemical solution, wherein
the supply pipe branches into a drain pipe connected to the supply pipe at a stage subsequent to the concentration control unit and a main pipe communicating from a connection unit of the drain pipe to a point of use, and
the main pipe is provided with a flow-measuring means, and the drain pipe is provided with a flow-regulating mechanism capable of corresponding to a measured value of the flow-measuring means.

2. The device for supplying liquid for semiconductor manufacturing according to claim 1, wherein a flow rate of the main pipe is capable of being controlled by setting a total flow rate of the main pipe and the drain pipe to approximately the maximum usage amount at the point of use and varying a flow rate of the drain pipe by the flow-regulating mechanism.

3. The device for supplying liquid for semiconductor manufacturing according to claim 1 or 2, wherein the flow-regulating mechanism is a valve, and a flow rate is regulated by regulating an opening degree of the valve.

4. The device for supplying liquid for semiconductor manufacturing according to claim 1 or 2, wherein the flow-regulating mechanism is a flow-regulating valve or a constant pressure valve.

5. The device for supplying liquid for semiconductor manufacturing according to any one of claims 1 to 4, wherein as a means for injecting the chemical solution, a pump or a transportation means that pressurizes a closed tank filled with a chemical solution with an inert gas and pushes out the chemical solution is used.

6. The device for supplying liquid for semiconductor manufacturing according to any one of claims 1 to 5, wherein the chemical solution is a conductive solute, the concentration control unit comprises a conductivity meter or an absorption photometer, and an amount of the chemical solution added is capable of being controlled based on a measured value of the conductivity meter or the absorption photometer.
control means to

7. The device for supplying liquid for semiconductor manufacturing according to any one of claims 1 to 5, wherein the chemical solution is a non-conductive solute, the concentration control unit comprises a TOC meter or an absorption photometer, and an amount of the chemical solution added is capable of being controlled based on a measured value of the TOC meter or the absorption photometer.
